(19) Europäisches Patentamt

European Patent Office

Office européen des brevets

(11) **EP 0 749 204 B1**

(12) **FASCICULE DE BREVET EUROPEEN**

(45) Date de publication et mention
de la délivrance du brevet:
**24.10.2001 Bulletin 2001/43**

(51) Int Cl.⁷: **H03C 1/54**

(21) Numéro de dépôt: **96201568.1**

(22) Date de dépôt: **06.06.1996**

(54) **Modulateur d'amplitude**

Amplitudenmodulator

Amplitude modulator

(84) Etats contractants désignés:
**DE FR GB**

(30) Priorité: **14.06.1995 FR 9507083**

(43) Date de publication de la demande:
**18.12.1996 Bulletin 1996/51**

(73) Titulaire: **Koninklijke Philips Electronics N.V.**
**5621 BA Eindhoven (NL)**

(72) Inventeur: **Klaeyle, Philippe**
**75008 Paris (FR)**

(74) Mandataire: **Charpail, François et al**
**Société Civile S.P.I.D.**
**156, Boulevard Haussmann**
**75008 Paris (FR)**

(56) Documents cités:
**EP-A- 0 086 525**          **EP-A- 0 226 255**
**WO-A-91/03882**           **US-A- 4 263 617**

## Description

La présente invention concerne un modulateur d'amplitude, comportant une paire différentielle de transistors, dite paire différentielle d'entrée, recevant un signal d'entrée modulant, et une cellule de Gilbert réalisant la multiplication d'un signal dit porteur avec le signal d'entrée modulant.

La cellule de Gilbert, qui constitue l'organe essentiel d'un tel modulateur est connue du document "A Precise Four-Quadrant Multiplier with Subnanosecond Response" de Barrie Gilbert, paru dans le IEEE Journal of Solid-State Circuits, vol. sc-3, n°4, en Décembre 1968.

Le circuit présenté par Barrie Gilbert, couramment utilisé dans les modulateurs d'amplitude, réalise la multiplication d'un signal d'entrée modulant, de la forme $Vm(t)=K1.\sin\omega_m t$, avec un signal porteur de la forme $Vc(t)=K2.\sin\omega_c t$. La paire différentielle composant l'étage du bas de la cellule de Gilbert reçoit le signal porteur Vc, tandis que les paires différentielles composant l'étage du haut de la cellule de Gilbert reçoivent le signal d'entrée modulant après amplification dans la paire différentielle d'entrée, auquel on ajoute une composante continue, appelée tension de décalage d'entrée qui peut être réalisée de différentes manières, par un système de pont diviseur de la tension d'alimentation, ou à partir d'une tension régulée, par exemple. Cette tension de décalage d'entrée réalise deux fonctions essentielles : elle permet au modulateur d'amplitude de fournir un signal de sortie en toutes circonstances, même en cas d'absence ou de nullité du signal d'entrée modulant. Elle permet d'autre part de fournir en sortie un signal Vout(t) comportant une composante proportionnelle au seul signal porteur. Le signal de sortie Vout est alors de la forme

$$Vout(t)=A.(1+K.\sin\omega_m t).\sin\omega_c t,$$

ce qui correspond bien à l'équation d'un signal modulé en amplitude.

La tension de décalage d'entrée présente en elle-même un inconvénient majeur. Sa valeur doit être du même ordre de grandeur que l'amplitude de variation de la tension d'entrée modulant. Selon le cas, elle peut être aussi faible que quelques milivolts, aussi est elle difficile à contrôler de manière précise et stable, ce qui est très gênant.

La présente invention a pour but de remédier à cet inconvénient, en proposant un modulateur d'amplitude dans lequel la tension de décalage d'entrée n'est plus nécessaire pour assurer l'existence du signal de sortie en cas d'absence de signal d'entrée, ni pour générer en sortie un signal dont l'équation correspond à celle d'un signal modulé décrite plus haut.

En effet, selon la présente invention, un modulateur d'amplitude du type défini dans le paragraphe introductif est caractérisé en ce qu'il comporte une paire différentielle de transistors recevant le signal porteur et dont le signal de sortie est ajouté au signal de sortie de la cellule de Gilbert.

Au lieu d'ajouter une composante continue au signal modulant, qui se voit multipliée par le signal porteur dans la cellule de Gilbert, un modulateur d'amplitude selon l'invention ajoute au signal résultant de la multiplication du signal modulant avec le signal porteur une composante proportionnelle au seul signal porteur.

Un modulateur d'amplitude selon l'invention élimine donc la nécessité de générer une tension de décalage d'entrée, puisque la composante issue de la paire différentielle recevant le signal porteur est toujours présente en sortie du modulateur, quel que soit l'état du signal d'entrée modulant, et permet de fournir un signal de sortie comportant une composante proportionnelle au seul signal porteur.

La stabilité de cette composante proportionnelle au seul signal porteur est améliorée par rapport à celle obtenue dans l'état présent de la technique, car elle ne dépend que de paramètres (sources de courant, résistances de dégénération d'émetteur des transistors composant la paire différentielle), dont une variation parasite serait uniforme pour l'ensemble du circuit ; les proportionnalités entre les différents signaux seraient donc conservées.

Une variante de l'invention présente un modulateur d'amplitude tel que décrit ci-dessus, caractérisé en ce qu'il comporte des commutateurs permettant de déconnecter la paire différentielle d'entrée du reste du modulateur d'amplitude.

Une telle variante de l'invention permet d'arrêter la modulation en amplitude sans nécessairement annuler le signal d'entrée modulant. De la sorte, le signal de sortie du modulateur ne présente plus que la composante proportionnelle au seul signal porteur. Une observation aisée du signal porteur à des fins de contrôle est ainsi rendue possible.

Ce dispositif permet également de choisir entre une modulation en amplitude de la porteuse ou une modulation en fréquence, celle-ci étant alors réalisée par action du signal modulant sur le dispositif générant le signal porteur par ailleurs.

L'invention concerne également sur un appareil servant à la conversion d'informations en des signaux ayant une forme compatible avec les standards télévision, comportant :

. une unité dite d'entrée recevant les informations et produisant des signaux de deux natures différentes, l'un dit signal audio, l'autre dit signal vidéo,

. un module de traitement du signal audio présentant une entrée et une sortie, lequel module inclut un oscillateur qui fournit un signal de sortie de fréquence réglable,

. un module de traitement du signal vidéo, présentant une entrée et une sortie,

**.** un additionneur présentant deux entrées et une sortie, lequel additionneur réalise la superposition des signaux présents aux sorties des modules de traitement des signaux audio et video,

**.** un mélangeur permettant l'adaptation à une fréquence nominale de la fréquence du signal présent à la sortie de l'additionneur,

caractérisé en ce que le module de traitement du signal audio comporte un modulateur d'amplitude tel que décrit plus haut, modulateur d'amplitude pour lequel le signal modulant est constitué par le signal audio produit par l'unité d'entrée, modulateur d'amplitude pour lequel le signal porteur est constitué par le signal de sortie de l'oscillateur, modulateur d'amplitude dont la sortie constitue la sortie du module de traitement du signal audio.

La description qui va suivre en regard des dessins annexés, donnés à titre d'exemples non-limitatifs, fera bien comprendre en quoi consiste l'invention et comment elle peut être réalisée.

- La figure 1 représente un schéma décrivant un modulateur d'amplitude selon l'invention,
- la figure 2 représente un schéma décrivant l'étage d'entrée recevant le signal d'entrée modulant selon une variante de l'invention, et
- la figure 3 représente un appareil servant à la conversion d'informations en des signaux ayant une forme compatible avec les standards télévision, dans lequel un modulateur d'amplitude selon l'invention est utilisé.

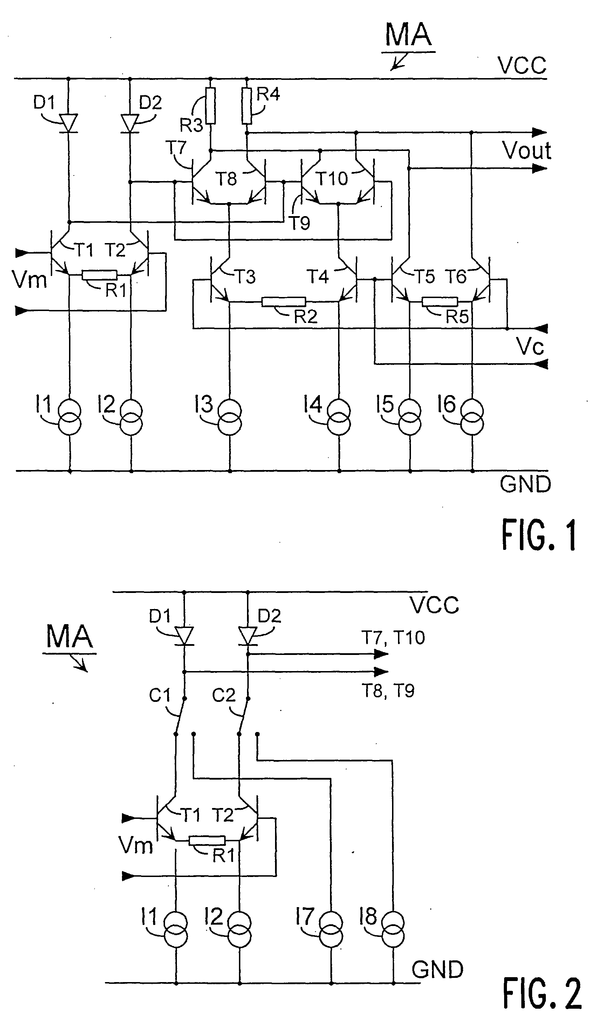

Selon la figure 1, un modulateur d'amplitude MA selon l'invention comporte une paire différentielle d'entrée, composée des transistors T1 et T2, recevant un signal d'entrée modulant Vm, qui est de la forme $Vm(t)=K1.\sin\omega_m t$, et une cellule de Gilbert, composée des transistors T3, T4, T7, T8, T9, T10, qui réalise la multiplication du signal porteur avec le signal d'entrée modulant, signal porteur qui est de la forme $Vc(t)=K2.\sin\omega_c t$.

La paire différentielle composant l'étage du bas de la cellule de Gilbert (transistors T3 et T4) reçoit le signal porteur Vc, tandis que les paires différentielles composant l'étage du haut de la cellule de Gilbert (transistors T7, T8 et T9, T10) reçoivent le signal d'entrée modulant après traitement dans la paire différentielle d'entrée. Une paire différentielle supplémentaire, composée des transistors T5 et T6, reçoit le signal porteur. Le signal de sortie Vout du modulateur MA est la somme du signal de sortie de cette paire différentielle supplémentaire avec le signal de sortie de la cellule de Gilbert.

Si V1 est le signal de sortie de la cellule de Gilbert, on a $V1(t)=K3.\sin\omega_m t.\sin\omega_c t$. Si V2 est le signal de sortie de la paire différentielle supplémentaire recevant le signal porteur, on a $V2(t)=K4.\sin\omega_c t$. Le signal de sortie Vout du modulateur MA, qui est la somme de ces deux signaux, se présente donc sous la forme

$$Vout(t)=A'.(1+K'.\sin\omega_m t).\sin\omega_c t.$$

ce qui correspond bien à l'équation d'un signal modulé en amplitude.

La figure 2 montre une variante de l'invention, selon laquelle un modulateur d'amplitude MA comporte des commutateurs permettant de déconnecter la paire différentielle d'entrée du reste du modulateur d'amplitude MA. Ces commutateurs peuvent être réalisés de différentes manières, par exemple avec des transistors. Une telle variante de l'invention permet d'arrêter la modulation sans nécessairement annuler le signal d'entrée modulant, en reliant les bases des transistors T7, T8, T9 et T10 à des sources de courant I7, I8, dont les sorties sont à des potentiels égaux. De la sorte, le signal de sortie du modulateur ne présente plus que la composante proportionnelle au seul signal porteur

$$Vout(t)=A' . \sin\omega_c t$$

Une observation aisée du signal porteur à des fins de contrôle est ainsi rendue possible.

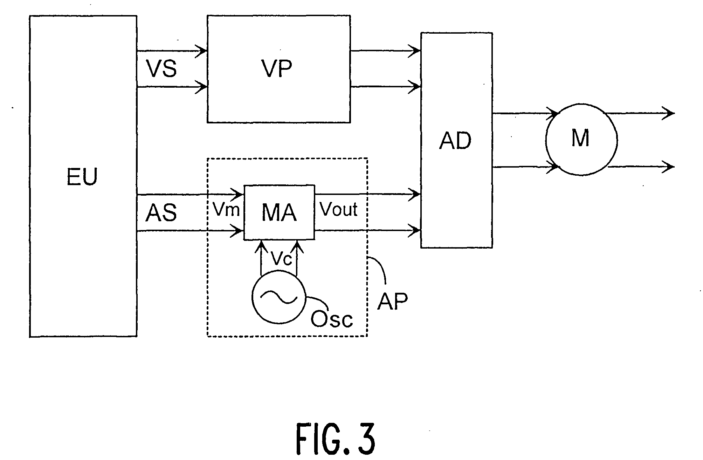

La figure 3 représente un appareil servant à la conversion d'informations en des signaux ayant une forme compatible avec les standards télévision, comportant :

**.** une unité dite d'entrée EU recevant les informations et produisant des signaux de deux natures différentes, l'un dit signal audio AS, l'autre dit signal vidéo VS,

**.** un module de traitement du signal audio AP présentant une entrée et une sortie, lequel module AP inclut un oscillateur Osc qui fournit un signal de sortie de fréquence réglable,

**.** un module de traitement du signal vidéo VP, présentant une entrée et une sortie,

**.** un additionneur AD présentant deux entrées et une sortie, lequel additionneur AD réalise la superposition des signaux présents aux sorties des modules de traitement des signaux audio et video,

**.** un mélangeur M permettant l'adaptation à une fréquence nominale de la fréquence du signal présent à la sortie de l'additionneur,

caractérisé en ce que le module de traitement du signal audio AP comporte un modulateur d'amplitude MA tel que décrit ci-dessus, modulateur d'amplitude MA pour lequel le signal modulant Vm est constitué par le signal audio produit par l'unité d'entrée EU, modulateur d'amplitude MA pour lequel le signal porteur Vc est constitué par le signal de sortie de l'oscillateur Osc, modulateur d'amplitude MA dont la sortie constitue la sortie du module de traitement du signal audio AP.

**Revendications**

1. Modulateur d'amplitude, comportant une paire différentielle de transistors, dite paire différentielle d'entrée, recevant un signal d'entrée modulant, et une cellule de Gilbert réalisant la multiplication d'un signal dit porteur avec le signal d'entrée modulant, **caractérisé en ce qu'**il comporte une paire différentielle de transistors recevant le signal porteur et dont le signal de sortie est ajouté au signal de sortie de la cellule de Gilbert.

2. Modulateur d'amplitude selon la revendication 1, **caractérisé en ce qu'**il comporte des commutateurs permettant de déconnecter la paire différentielle d'entrée du reste du modulateur d'amplitude.

3. Modulateur d'amplitude selon la revendication 2, **caractérisé en ce que** les commutateurs permettant de déconnecter la paire différentielle d'entrée du reste du modulateur d'amplitude sont réalisés avec des transistors.

4. Appareil servant à la conversion d'informations en des signaux ayant une forme compatible avec les standards télévision, comportant :

   . une unité dite d'entrée recevant les informations et produisant des signaux de deux natures différentes, l'un dit signal audio, l'autre dit signal vidéo,
   . un module de traitement du signal audio présentant une entrée et une sortie, lequel module inclut un oscillateur qui fournit un signal de sortie de fréquence réglable,
   . un module de traitement du signal vidéo, présentant une entrée et une sortie,
   . un additionneur présentant deux entrées et une sortie, lequel additionneur réalise la superposition des signaux présents aux sorties des modules de traitement des signaux audio et video,
   . un mélangeur permettant l'adaptation à une fréquence nominale de la fréquence du signal présent à la sortie de l'additionneur,

   **caractérisé en ce que** le module de traitement du signal audio comporte un modulateur d'amplitude selon l'une des revendications 1 à 3, modulateur d'amplitude pour lequel le signal modulant est constitué par le signal audio produit par l'unité d'entrée, modulateur d'amplitude pour lequel le signal porteur est constitué par le signal de sortie de l'oscillateur, modulateur d'amplitude dont la sortie constitue la sortie du module de traitement du signal audio.

**Patentansprüche**

1. Amplitudenmodulator mit einem Transistor-Differentialpaar, einem sogenannten Eingangs-Differentialpaar, das ein modulierendes Eingangssignal erhält, und einer Gilbert-Zelle, die die Multiplikation eines sogenannten Trägersignals mit dem modulierenden Eingangssignal vornimmt, **dadurch gekennzeichnet, daß** er ein das Trägersignal erhaltendes Transistor-Differentialpaar enthält, dessen Ausgangssignal dem Ausgangssignal der Gilbert-Zelle hinzugefügt wird.

2. Amplitudenmodulator nach Anspruch 1, **dadurch gekennzeichnet, daß** er Schalter aufweist, die es ermöglichen, das Eingangs-Differentialpaar vom Rest des Amplitudenmodulators zu trennen.

3. Amplitudenmodulator nach Anspruch 2, **dadurch gekennzeichnet, daß** die Schalter aufweist, die es ermöglichen, das Eingangs-Differentialpaar vom Rest des Amplitudenmodulators zu trennen, aus Transistoren erstellt werden.

4. Gerät zur Umwandlung von Informationen in Signale mit einer für Fernsehnormen kompatiblen Form, bestehend aus:

   . einer sogenannten Eingangseinheit für den Erhalt der Informationen und die Erzeugung zweier Signale verschiedener Arten, dem sogenannten Tonsignal und dem sogenannten Bildsignal,
   . einem Modul zur Verarbeitung des Tonsignals mit einem Eingang und einem Ausgang, wobei das Modul einen Oszillator aufweist, der ein frequenzregulierbares Ausgangssignal liefert,
   . einem Modul zur Verarbeitung des Bildsignals mit einem Eingang und einem Ausgang,
   . einem Addierer mit zwei Eingängen und einem Ausgang, wobei der Addierer die Überlagerung der an den Ausgängen der Module zur Verarbeitung der Ton- und Bildsignale vorhandenen Signale vornimmt,
   . einem Mischer zur Angleichung der Frequenz des am Ausgang des Addierers vorhandenen Signals an eine Nennfrequenz,

   **dadurch gekennzeichnet, daß** das Modul zur Verarbeitung des Tonsignals einen Amplitudenmodulator nach einem der Ansprüche 1 bis 3 aufweist, wobei das modulierende Signal für den Amplitudenmodulator von dem in der Eingangseinheit erzeugten Tonsignal gebildet wird, das Trägersignal für den Amplitudenmodulator vom Ausgangssignal des Oszillators gebildet wird und der Ausgang des Amplitudenmodulators den Ausgang des Moduls zur Verarbeitung des Tonsignals bildet.

## Claims

1. An amplitude modulator comprising a differential pair of transistors called differential input pair receiving a modulating input signal, and a Gilbert cell multiplying a signal called carrier signal by the modulating input signal, **characterized in that** it comprises a differential pair of transistors receiving the carrier signal and in which the output signal of which differential pair being added to the output signal of the Gilbert cell.

2. An amplitude modulator as claimed in Claim 1, **characterized in that** it comprises switches which permit of the disconnection of the differential input pair from the rest of the amplitude modulator.

3. An amplitude modulator as claimed in Claim 2, **characterized in that** the switches which permit of the disconnection of the long-tail input pair from the rest of the amplitude modulator are realized by transistors.

4. An apparatus for converting data into signals having a TV-standard compatible form, comprising:

   . a unit, called entry unit, which receives the data and produces signals of two different kinds, one called audio signal, the other called video signal,
   . an audio signal processing module featuring one input and one output, which module includes an oscillator which provides a frequency-tunable output signal,
   . a video signal processing module featuring one input and one output,
   . an adder featuring two inputs and one output, which adder performs a superposition of the signals which are available at the outputs of the audio and video signal processing modules,
   . a mixer enabling the tuning to a nominal frequency of the frequency of the signal which is available at the output of the adder,

   **characterized in that** the audio signal processing module comprises an amplitude modulator as claimed in claims 1 to 3, amplitude modulator for which the modulating signal is constituted by the audio signal produced by the entry unit, amplitude modulator for which the carrier signal is constituted by the output signal of the oscillator, amplitude modulator whose output signal constitutes the output of the audio signal processing module.

FIG. 1

FIG. 2

FIG. 3

EP 0 749 204 B1